**Europäisches Patentamt**

**European Patent Office**

**Office européen des brevets**

(11) Veröffentlichungsnummer : **0 349 833 B1**

(12)

# EUROPÄISCHE PATENTSCHRIFT

(45) Veröffentlichungstag der Patentschrift :
**11.11.92 Patentblatt 92/46**

(51) Int. Cl.$^5$ : **C25D 7/06, // H05K3/00**

(21) Anmeldenummer : **89111308.6**

(22) Anmeldetag : **21.06.89**

(54) **Galvanisiereinrichtung für plattenförmige Werkstücke, insbesondere Leiterplatten.**

(30) Priorität : **07.07.88 DE 3823072**

(43) Veröffentlichungstag der Anmeldung :
**10.01.90 Patentblatt 90/02**

(45) Bekanntmachung des Hinweises auf die
Patenterteilung :
**11.11.92 Patentblatt 92/46**

(84) Benannte Vertragsstaaten :
**AT BE CH DE FR GB LI NL**

(56) Entgegenhaltungen :
**EP-A- 0 086 115**
**EP-A- 0 276 725**
**US-A- 4 459 183**

(73) Patentinhaber : **Siemens Nixdorf
Informationssysteme AG
Otto-Hahn-Ring 6
W-8000 München 83 (DE)**

(72) Erfinder : **Hosten, Daniel
Staatsbaan 147
B-8120 Handzame (BE)**
Erfinder : **Flögel, Lothar, Dr.
Neunerstrasse 7
W-8027 Neuried (DE)**

(74) Vertreter : **Fuchs, Franz-Josef, Dr.-Ing. et al
Postfach 22 13 17
W-8000 München 22 (DE)**

**Beschreibung**

Die Erfindung betrifft eine Galvanisiereinrichtung für im horizontalen Durchlauf zu behandelnde plattenförmige Werkstücke, insbesondere gelochte Leiterplatten, mit mindestens einer oberhalb und mindestens einer unterhalb der Durchlaufbahn parallel dazu angeordneten Anode, wobei einlaufseitig und auslaufseitig jeweils oberhalb und unterhalb der Durchlaufbahn quer dazu ausgerichtete Elektrolytsammler mit zwischen Durchlaufbahn und oberer bzw. unterer Anode gerichteten Öffnungen für den Zulauf und/oder Ablauf von Elektrolytlösung angeordnet sind.

Eine derartige Galvanisiereinrichtung ist Gegenstand der älteren europäischen Patentanmeldung entsprechend der EP-A-0 276 725. (Stand der Technik nach Artikel 54(3) EPÜ). Mit der dort beschriebenen Galvanisiereinrichtung kann die Qualität der galvanisch abgeschiedenen Schichten insbesondere im Hinblick auf eine gleichmäßige Schichtdickenverteilung, eine hohe Haftfestigkeit und eine gute Duktilität gegenüber den herkömmlich ausgebildeten Galvanisiereinrichtungen verbessert werden.

Der älteren Anmeldung liegt die Erkenntnis zugrunde, daß qualitativ hochwertige Oberflächen der galvanisch abgeschiedenen Schichten nur durch in Durchlaufrichtung der Werkstücke gerichtete Strömungskomponenten der Elektrolytflüssigkeit gewährleistet werden können und daß derartige Strömungskomponenten in Längsrichtung durch die beschriebene Anordnung der Elektrolytsammler realisiert werden können. Vertikal auf die Oberfläche der Werkstücke gerichtete Strömungskomponenten sollen hierbei jedoch nicht ausgeschlossen werden, da sie für die Herstellung von Durchkontaktierungen in gelochten Leiterplatten nach wie vor wichtig sein können.

Die Strömungskomponenten in Längsrichtung können sowohl durch den Zulauf als auch den Ablauf von Elektrolytlösungen durch die Öffnungen der Elektrolytsammler erzeugt werden. Besonders günstige Ergebnisse werden jedoch erzielt, wenn mindestens ein Elektrolytsammler für den Zulauf von Elektrolytlösungen bestimmt ist.

Gemäß einer bevorzugten Ausgestaltung der gattungsgemäßen Galvanisiereinrichtung sind zwei Elektrolytsammler für den Zulauf und zwei Elektrolytsammler für den Ablauf von Elektrolytlösung bestimmt. Eine weitere Verbesserung der Qualität der galvanisch abgeschiedenen Schichten kann in diesem Fall dann erzielt werden, wenn die beiden auslaufseitig angeordneten Elektrolytsammler für den Zulauf von Elektrolytlösung bestimmt sind. Dies bedeutet mit anderen Worten, daß hier die Strömungskomponente in Längsrichtung der Durchlaufrichtung der Werkstücke entgegengesetzt ist.

Weiterhin hat es sich insbesondere für eine gute Durchflutung der Löcher in Leiterplatten als sehr günstig erwiesen, wenn die Elektrolytlösung der beiden für den Zulauf bestimmten Elektrolytsammler über separate Pumpen zuführbar ist. Eine besonders effektive Durchflutung der Löcher kann dadurch erzielt werden, daß dem oberhalb der Durchlaufbahn angeordneten Elektrolytsammler eine größere Menge an Elektrolytlösung zugeführt wird, als dem unterhalb der Durchlaufbahn angeordneten Elektrolytsammler. Dies ist insbesondere dann von Vorteil, wenn die Werkstücke von unten her zusätzlich geschwallt werden.

Gemäß einer weiteren Ausgestaltung der gattungsgemäßen Galvanisiereinrichtung ist vorgesehen, daß die Öffnungen unter einem geringen Anstellwinkel schräg auf die Durchlaufbahn gerichtet sind. Durch diese konstruktiv einfach zu realisierende Maßnahme kann dann die Aus- oder Eintrittsmündung der Öffnungen sehr dicht an die Oberfläche der durchlaufenden Werkstücke herangebracht werden.

Es hat sich auch als vorteilhaft erwiesen, wenn die Öffnungen in Form von gleichmäßig über die Breite der Durchlaufbahn angeordneten Bohrungen in die Elektrolytsammler eingebracht sind. Derartige Öffnungen ermöglichen bei einem gegenüber in Querrichtung durchgehenden Schlitzen geringeren konstruktiven Aufwand eine gleichmäßigere Verteilung der erwünschten Strömungskomponente.

Im Hinblick auf eine optimale Durchflutung der Löcher in gelochten Leiterplatten ist es auch zweckmäßig, wenn zwischen den beiden unterhalb der Durchlaufbahn angeordneten Elektrolytsammlern und unterhalb der sieb- oder gitterförmig ausgebildeten, unlöslichen unteren Anode mehrere quer zur Durchlaufbahn ausgerichtete und mit Elektrolytlösung beaufschlagbare Schwalldüsen angeordnet sind. Die Unterbringung der Schwalldüsen im Elektrolytbad wird dabei durch die sieb- oder gitterförmige Ausbildung einer unlöslichen unteren Anode erheblich erleichtert. Die Schwalldüsen sind dann vorzugsweise als Schlitzrohre ausgebildet, die sich hier für die Durchflutung günstiger als Bohrungen erwiesen haben. Sind die Schwalldüsen über eine separate Pumpe mit Elektrolytlösung beaufschlagbar, so können die Bedingungen der Elektrolytbewegung insgesamt noch besser optimiert und auf die jeweiligen Besonderheiten der zu behandelnden Werkstücke abgestimmt werden.

Schließlich hat es sich auch als besonders günstig herausgestellt, wenn die obere Anode als lösliche Anode mit auf einem sieb- oder gitterförmigen Träger angeordneten, löslichen Anodenmaterial ausgebildet ist. Es werden also die Vorteile einer löslichen Anode erzielt, wobei gleichzeitig ein gleichbleibender Abstand zu den durchlaufenden Werkstücken gewährleistet ist. Insbesondere durch die Kombination einer derartigen oberen Anode mit einer unlöslichen unteren Anode werden im Hinblick auf die Streuung der Schichtdicken und die Schichtdickenverteilung auf der Oberfläche der Werkstücke optimale Bedingungen bei einfacher Wartung der Galvanisiereinrichtung erreicht.

Beim Einsatz von Glanzmitteln kann jedoch eine Kombination von oberer löslicher Anode und unterer unlöslicher Anode zu einem erhöhten Glanzmittelverbrauch führen. Aus diesem Grunde ist bei der Verwendung von Glanzmittel enthaltenden Elektrolytlösungen eine Ausgestaltung von oberer und unterer Anode als lösliche Anode vorzuziehen.

Der vorliegenden Erfindung liegt die Aufgabe zugrunde, bei einer gattungsgemäßen Galvanisiereinrichtung die Elektrolytbewegung weiter zu verbessern.

Diese Aufgabe wird erfindungsgemäß dadurch gelöst, daß zwischen den beiden oberhalb der Durchlaufbahn angeordneten Elektrolytsammlern mehrere quer zur Durchlaufbahn ausgerichtete mit Elektrolytlösung beaufschlagbare obere Schwalldüsen angeordnet sind. Mit einer derartigen zusätzlichen Anordnung der oberen Schwalldüsen kann die Elektrolytbewegung weiter verbessert werden, wobei insbesondere die intensive Durchflutung der Durchkontaktierungen gelochter Leiterplatten hervorzuheben ist. Die oberen Schwalldüsen sind dann vorzugsweise als Schlitzrohre ausgebildet, die sich auch hier für die Durchflutung günstiger als Bohrungen erwiesen haben. Sind die oberen Schwalldüsen über eine separate Pumpe mit Elektrolytlösung beaufschlagbar, so können die Bedingungen der Elektrolytbewegung auch hier wiederum besser auf die jeweiligen Besonderheiten der zu behandelnden Werkstücke abgestimmt werden.

Schließlich hat es sich im Hinblick auf die Qualität der abgeschiedenen Schichten als besonders günstig herausgestellt, wenn die oberen Schwalldüsen im Bereich der oberen Anode angeordnet sind. Bei Verwendung einer oberen löslichen Anode ist dann vorzugsweise vorgesehen, daß die oberen Schwalldüsen oberhalb des sieb- oder gitterförmigen Trägers der oberen löslichen Anode angeordnet sind und zumindest teilweise vom löslichen Anodenmaterial umgeben sind.

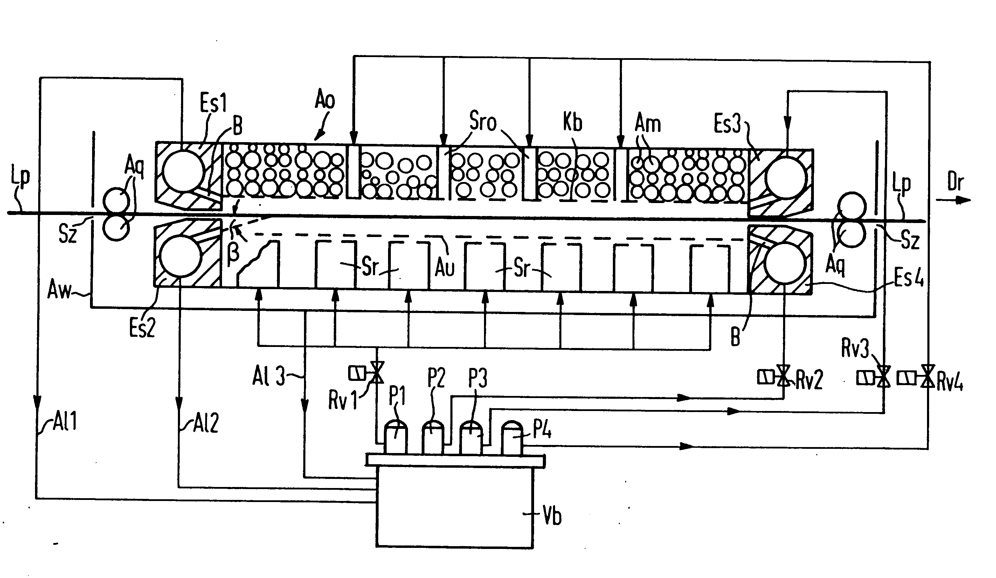

Ein Ausführungsbeispiel der Erfindung ist in der Zeichnung dargestellt und wird im folgenden näher beschrieben.

Die Zeichnung zeigt in stark vereinfachter schematischer Darstellung die Galvanisiereinrichtung einer Horizontal-Durchlaufanlage zum Durchkontaktieren und Galvanisieren von Leiterplatten. Die einzelnen zu galvanisierenden gelochten Leiterplatten Lp werden nacheinander auf einer horizontalen Durchlaufbahn durch eine nicht näher dargestellte Elektrolytlösung geführt, die sich in einer mit Aw bezeichneten Auffangwanne befindet. In Durchlaufrichtung Dr gesehen werden die Leiterplatten Lp durch einen horizontalen einlaufseitigen Schlitz Sz der Auffangwanne Aw zwei einlaufseitigen Abquetschwalzen Aq zugeführt, dann mit Hilfe von nicht näher dargestellten Transportmitteln zwischen einer oberen Anode Ao und einer unteren Anode Au durch die Elektrolytlösung transportiert bis sie die Galvanisiereinrichtung dann wieder über auslaufseitige Abquetschwalzen Aq und einen horizontalen auslaufseitigen Schlitz Sz der Auffangwanne Aw wieder verlassen. Zumindest im Bereich zwischen der oberen Anode Ao und der unteren Anode Au werden die einzelnen Leiterplatten Lp über ebenfalls nicht näher dargestellte Kontaktiereinrichtungen kathodisch kontaktiert. Bei der im geringen Abstand über der Durchlaufbahn der Leiterplatten Lp horizontal angeordneten oberen Anode Ao handelt es sich um eine lösliche Anode, die aus einem Korb Kb und darin in einer Lage oder in mehreren Lagen angeordnetem Anodenmaterial Am besteht. Der aus Streckmetall gebildete Boden des insgesamt aus Titan bestehenden Korbes Kb bildet einen für die Elektrolytlösung leicht durchlässigen Träger für das Anodenmaterial Am. Im vorliegenden Fall handelt es sich bei der Elektrolytlösung um ein Kupferbad und bei dem Anodenmaterial Am um Kupferkugeln die häufig auch als Cu-Pellets bezeichnet werden. Die horizontal ausgerichtete untere Anode Au ist als unlösliche Anode ausgebildet und in geringem Abstand unter der Durchlaufbahn der Leiterplatten Lp angeordnet. Durch die Ausbildung als Streckmetallsieb aus platiniertem Titan wird auch hier eine Behinderung des Elektrolytaustausches und der Strömung der Elektrolytlösung ausgeschlossen. Im übrigen hat die dargestellte Kombination aus löslicher oberer Anode Ao und unlöslicher unterer Anode Au den Vorteil, daß der Abstand zu den dazwischen durchlaufenden Leiterplatten Lp konstant bleibt und somit im Hinblick auf die Streuung der Schichtdicke und die Schichtdickenverteilung auf der Oberfläche optimale Bedingungen erreicht werden.

Um beim galvanischen Aufbau der Leiterbahnen und Durchkontaktierungen der Leiterplatten Lp eine Abscheidung glänzender Kupferschichten zu gewährleisten werden an die Elektrolytbewegung besondere Anforderungen gestellt. Hierzu sind im Bereich unter der unteren Anode Au mehrere quer zur Durchlaufbahn ausgerichtete Schlitzrohre Sr angeordnet, die aus einem Vorratsbehälter Vb über eine Pumpe P1 mit Elektrolytlösung beaufschlagt werden, wobei die Menge über ein Regelventil Rv1 variiert werden kann. Die Schlitze der Schlitzrohre Sr sind dabei so ausgerichtet, daß die Leiterplatten Lp im wesentlichen in vertikaler Richtung von unten her angeströmt werden.

Da die Schlitzrohre Sr allein noch nicht die Abscheidung glänzender Kupferschichten gewährleisten sind zusätzlich noch einlaufseitig und auslaufseitig jeweils oberhalb und unterhalb der Durchlaufbahn quer dazu ausgerichtete Elektrolytsammler Es1, Es2, Es3 und Es4 vorgesehen. Jeder dieser Elektrolytsammler Es1 bis Es4 besitzt mehrere gleichmäßig über die Breite der Durchlaufbahn angeordnete Bohrungen B, die unter einem geringen Anstellwinkel β von beispielsweise 10° schräg auf die Durchlaufbahn und in den spaltförmigen Bereich zwischen Durchlaufbahn und oberer Anode Ao bzw. unterer Anode, Au gerichtet sind.

Der auslaufseitig unterhalb der Durchlaufbahn angeordnete Elektrolytsammler Es4 wird über eine Pumpe P2 aus dem Vorratsbehälter Vb mit Elektrolytlösung beaufschlagt, wobei die Menge über ein Regelventil Rv2 variiert werden kann. Aus den Bohrungen B des Elektrolytsammlers Es4 tritt die zugeführte Elektrolytlösung dann mit einer im wesentlichen horizontalen Geschwindigkeitskomponente aus, die auf der Unterseite der Leiterplatten Lp verläuft und der Durchlaufrichtung Dr entgegengesetzt ist.

Der auslaufseitig oberhalb der Durchlaufbahn angeordnete Elektrolytsammler Es3 wird über eine Pumpe P3 aus dem Vorratsbehälter Vb mit Elektrolytlösung beaufschlagt, wobei die Menge über ein Regelventil Rv3 variiert werden kann. Aus den Bohrungen B des Elektrolytsammlers Es3 tritt die zugeführte Elektrolytlösung dann mit einer im wesentlichen horizontalen Geschwindigkeitskomponente aus, die auf der Oberseite der Leiterplatten Lp verläuft und der Durchlaufrichtung Dr entgegengesetzt ist.

Die horizontalen Geschwindigkeitskomponenten der Elektrolytströmung an der Oberseite und Unterseite der Leiterplatten Lp werden durch die einlaufseitigen Elektrolytsammler Es1 bzw. Es2 weiter begünstigt, da diese für den Ablauf von Elektrolytlösung bestimmt sind und über Ablauf-Leitungen AL1 bzw. AL2 mit dem Vorratsbehälter Vb verbunden sind. Zur weiteren Verbesserung der Elektrolytumwälzung ist auch die Auffangwanne Aw über eine Ablauf-Leitung AL3 mit dem Vorratsbehälter Vb verbunden.

Bei dem vorstehend erläuteren Ausführungsbeispiel wird eine Elektrolytbewegung mit einer sehr guten Durchflutung der Löcher der Leiterplatten Lp und einer starken Elektrolytströmung entlang der Leiterplattenoberfläche erzielt. Dabei wurden folgende Parameter eingestellt:

Durchlaufmenge Pumpe P1:     20.000 l/h
Austrittsgeschwindigkeit:     1/m/s
Durchlaufmenge Pumpe P2:     20.000 l/h
Austrittsgeschwindigkeit:     2,8 m/s
Durchlaufmenge Pumpe P3:     20.000 l/h
Austrittsgeschwindigkeit:     2,8 m/s

Das beschriebene Ausführungsbeispiel stellt lediglich eine bevorzugte erste Möglichkeit für die Elektrolytbewegung mit Hilfe der Elektrolytsammler Es1 bis Es4 und der Schlitzrohre Sr dar. Weitere Möglichkeiten, die jedoch noch keine abschließende Aufzählung darstellen sollen, gehen aus der nachfolgenden Tabelle hervor.

|  | Es1 | Es2 | Es3 | Es4 | Sr |
|---|---|---|---|---|---|
| 1. Möglichkeit | Ablauf | Ablauf | Zulauf | Zulauf | Zulauf |
| 2. Möglichkeit | Zulauf | Zulauf | Ablauf | Ablauf | Zulauf |
| 3. Möglichkeit | Ablauf | Zulauf | Ablauf | Zulauf | Zulauf |
| 4. Möglichkeit | Zulauf | Ablauf | Ablauf | Zulauf | Zulauf |

Es ist zu erkennen, daß die geschilderte Anordnung der Elektrolytsammler eine breitgefächerte Beeinflussung der Elektrolytlösung und eine flexible Anpassung an die jeweils zu galvanisierenden Werkstücke ermöglicht.

Zur weiteren Verbesserung der Elektrolytbewegung sind im Bereich der oberen Anode A mehrere quer zur Durchlaufbahn ausgerichtete obere Schlitzrohre Sro angeordnet, die aus dem Vorratsbehälter Vb über eine Pumpe P4 mit Elektrolytlösung beaufschlagt werden, wobei die Menge über ein Regelventil Rv4 variiert werden kann. Die Schlitze der innerhalb des Anodenmaterials Am angeordneten oberen Schlitzrohre Sro sind dabei so ausgerichtet, daß die Leiterplatten Lp durch den Boden des Korbes Kb hindurch im wesentlichen in vertikaler Richtung von oben her angeströmt werden. Im Hinblick auf die oberen Schlitzrohre werden folgende Parameter eingestellt.

Durchlaufpumpe Pumpe P4:    20.000 l/h

Austrittsgeschwindigkeit:    2,5 m/s

**Patentansprüche**

1. Galvanisierungseinrichtung für im horizontalen Durchlauf zu behandelnde plattenförmige Werkstücke, insbesondere gelochte Leiterplatten (Lp), mit mindestens einer oberhalb und mindestens einer unterhalb der Durchlaufbahn parallel dazu angeordneten Anode (Ao, Au), wobei einlaufseitig und auslaufseitig jeweils oberhalb und unterhalb der Durchlaufbahn quer dazu ausgerichtete Elektrolytsammler (Es1, Es2, Es3, Es4) mit zwischen Durchlaufbahn und oberer bzw. unterer Anode (Ao, Au) gerichteten Öffnungen für den Zulauf und/oder Ablauf von Elektrolytlösung angeordnet sind,
**dadurch gekennzeichnet,**
daß zwischen den beiden oberhalb der Durchlaufbahn angeordneten Elektrolytsammlern (Es1, Es3) mehrere quer zur Durchlaufbahn ausgerichtete mit Elektrolytlösung beaufschlagbare obere Schwalldüsen angeordnet sind.

2. Galvanisiereinrichtung nach Anspruch 1,
**dadurch gekennzeichnet,**
daß die oberen Schwalldüsen als obere Schlitzrohre (Sro) ausgebildet sind.

3. Galvanisiereinrichtung nach Anspruch 1 oder 2,
**dadurch gekennzeichnet,**
daß die oberen Schwalldüsen über eine separate Pumpe (P4) mit Elektrolytlösung beaufschlagbar sind.

4. Galvanisiereinrichtung nach einem der vorhergehenden Ansprüche,
**dadurch gekennzeichnet,**
daß die oberen Schwalldüsen im Bereich der oberen Anode (Ao) angeordnet sind.

5. Galvanisiereinrichtung nach Anspruch 4,
**dadurch gekennzeichnet,**
daß die oberen Schwalldüsen oberhalb des sieb- oder gitterförmigen Trägers der oberen löslichen Anode (Ao) angeordnet sind und zumindest teilweise von löslichen Anodenmaterial (Am) umgeben sind.

**Claims**

1. Electroplating apparatus for panel-type workpieces to be treated while passing through horizontally, in particular perforated printed circuit boards (Lp), which apparatus has at least one anode (Ao) disposed above, and at least one anode (Au) disposed below, the throughput path and parallel to it, electrolyte headers (Es1, Es2, Es3, Es4) which are directed transversely to the throughput path and have electrolyte solution inlet and/or outlet openings directed between the throughput path and the upper and lower anode (Ao, Au), respectively, being disposed at the inlet and outlet side above and below the throughput path in each case, characterised in that a plurality of upper flooding jets directed transversely to the throughput path and fed with electrolyte solution are disposed between the two electrolyte headers (Es1, Es3) disposed above the throughput path.

2. Electroplating apparatus according to Claim 1, characterised in that the upper flooding jets are designed as upper slotted tubes (Sro).

3. Electroplating apparatus according to Claim 1 or 2, characterised in that the upper flooding jets can be fed with electrolyte solution by means of a separate pump (P4).

4. Electroplating apparatus according to one of the preceding claims, characterised in that the upper flooding jets are disposed in the region of the upper anode (Ao).

5. Electroplating apparatus according to Claim 4, characterised in that the upper flooding jets are disposed above the sieve-type or grid-type carrier of the upper soluble anode (Ao) and are at least partially surrounded by soluble anode material (Am).

**Revendications**

1. Dispositif de galvanisation pour des pièces en forme de plaques traitées lors de leur déplacement horizontal, notamment des plaques à circuits imprimés perforées (Lp), comportant au moins une anode (Ao) disposée à cet effet parallèlement et au-dessus de la voie de déplacement et au moins une anode (Au) disposée à cet effet parallèlement et au-dessous de la voie de déplacement, dans lequel, côté entrée et côté sortie, des dispositifs (Es1, Es2, Es3, Es4) de collecte de l'électrolyte, qui sont orientés transversalement par rapport à la voie de déplacement et comportent des ouvertures orientées entre la voie de déplacement et l'anode supérieure ou inférieure (Ao, Au), pour l'arrivée et/ou l'évacuation de la solution d'électrolyte, sont disposés côté entrée et côté sortie respectivement au-dessus et au-dessous de la voie de déplacement, caractérisé par le fait qu'entre les deux dispositifs (Es1, Es3) de collecte de l'électrolyte situés au-dessus de la voie de déplacement sont disposées plusieurs buses supérieures de projection, qui sont dirigées transversalement par rapport à la voie de déplacement et qui peuvent être chargées par la solution d'électrolyte.

2. Dispositif de galvanisation suivant la revendication 1, caractérisé par le fait que les buses supérieures de projection sont agencées sous la forme de tubes supérieurs à fentes (Sro).

3. Dispositif de galvanisation suivant la revendication 1 ou 2, caractérisé par le fait que les buses supérieures de pulvérisation peuvent être chargées avec une solution d'électrolyte par l'intermédiaire d'une pompe séparée (P4).

4. Dispositif de galvanisation suivant l'une des revendications précédentes, caractérisé par le fait que les buses supérieures de projection sont disposées au voisinage de l'anode supérieure (Ao).

5. Dispositif de galvanisation suivant la revendication 4, caractérisé par le fait que les buses supérieures de projection sont disposées au-dessus du support en forme de tamis ou de grille de l'anode supérieure soluble (Ao) et sont entourées au moins en partie par un matériau d'anode soluble (Am).

Es1　B　Ao　Sro　Kb　Am　Es3

Lp　Aq　Dr

Sz　Sz

β　Sr　Au　Sr　Aq

Aw　Es4

Es2　B

Rv3

Al3　Rv1　P1　P2　P3　Rv2　Rv4

Al1　Al2　P4

Vb

EP 0 349 833 B1